(19) Europäisches Patentamt

European Patent Office

Office européen des brevets

(11) Publication number: **0 289 343 B1**

## EUROPEAN PATENT SPECIFICATION

(45) Date of publication of patent specification: **30.09.92**  (51) Int. Cl.⁵: **H01L 29/72**

(21) Application number: **88303920.8**

(22) Date of filing: **29.04.88**

(54) Heterojunction bipolar transistors.

(30) Priority: **30.04.87 JP 107352/87**

(43) Date of publication of application:
**02.11.88 Bulletin 88/44**

(45) Publication of the grant of the patent:
**30.09.92 Bulletin 92/40**

(84) Designated Contracting States:
**DE FR GB NL**

(56) References cited:
**EP-A- 0 039 015**
**WO-A-86/01939**
**DE-A- 1 464 286**

**IEEE TRANSACTIONS ON ELECTRON DEVICES, vol. ED-32, no. 11, November 1985, pages 2345-2377, IEEE, New York, US; G.W. TAYLOR et al.: "The bipolar inversion channel field-effect transistor (BICFET) - a new field-effect solid-state device: theory and structures"**

(73) Proprietor: **SONY CORPORATION**
**7-35 Kitashinagawa 6-chome Shinagawa-ku Tokyo 141(JP)**

(72) Inventor: **Kawai, Hiroji c/o Patents Division Sony Corporation 6-7-35, Kitashinagawa Shinagawa-ku Tokyo 141(JP)**

(74) Representative: **Cotter, Ivan John et al D. YOUNG & CO. 10 Staple Inn London WC1V 7RD(GB)**

## Description

This invention relates to heterojunction bipolar transistors, to methods of manufacturing such transistors, and to semiconductor integrated circuits comprising such transistors.

Generally, a previously proposed heterojunction bipolar transistor (hereinafter also referred to as "HJBT") can overcome shortcomings encountered with a homojunction bipolar transistor formed of silicon. By way of example, a description is given below of an HJBT having an AlGaAs emitter, a GaAs base and a GaAs collector. According to this HJBT, holes (the majority carrier in the base) cannot be diffused into the emitter due to an energy barrier caused by a band gap difference ($\Delta Eg$) between the emitter and the base. As a result, the base current is decreased and the efficiency of electron injection from the emitter to the base is increased. Thus, even if the base concentration is decreased, it is possible to increase the current gain ($\beta = I_c/I_B$). This means that the base resistance and the junction capacitance between the base and the emitter relating to high operational speed can be reduced. Experimentally, it has been proven that this HJBT can be operated at a speed higher than that of a bipolar transistor formed of silicon.

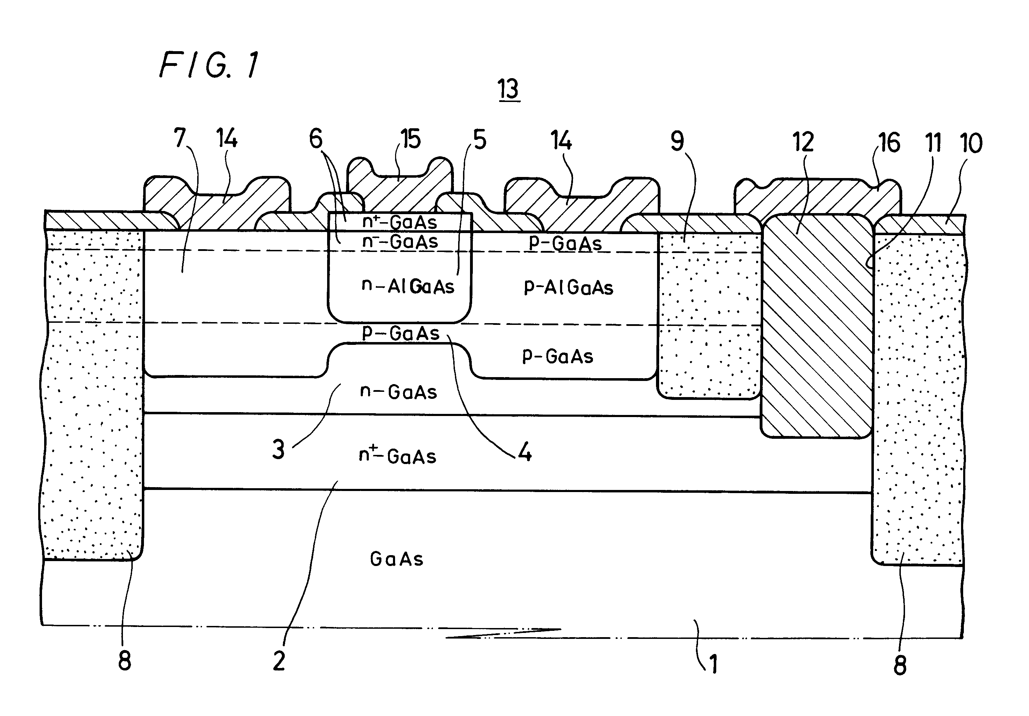

Figure 1 of the accompanying drawings shows an example of a typical previously proposed AlGaAs/GaAs planar HJBT 13 manufactured by employing an ion implantation technique and a metal burying technique. An example of a method of manufacturing this AlGaAs/GaAs planar HJBT having this structure will now be described briefly.

The AlGaAs/GaAs planar HJBT 13 comprises a semi-insulating GaAs substrate 1 on which there are epitaxially grown, in the following order, an $n^+$-GaAs layer which will become a collector electrode deriving layer 2, an n-GaAs layer which will become a collector region 3, a p-GaAs layer which will become a base region (intrinsic base region) 4, an n-AlGaAs layer which will become an emitter region 5, and an $n^-$-GaAs layer and an $n^+$-GaAs layer which will become a capping layer 6. Then, the $n^+$-GaAs capping layer 6 is etched away so as to leave the emitter region, and ion implantation of Mg is carried out by using an $SiO_2$ mask and an external base region 7 is formed by an annealing process. Then, ion implantation of boron B or $H^+$ is carried out to form an element separating region 8 and a base/collector separating region 9. Thereafter, a window is formed through an $SiO_2$ layer 10 on the collector electrode forming region to form a trench (groove) 11 and metal 12 is buried in the trench 11, whereby the HJBT 13 is formed. The HJBT 13 is provided with a base electrode 14, an emitter electrode 15 and a collector electrode 16.

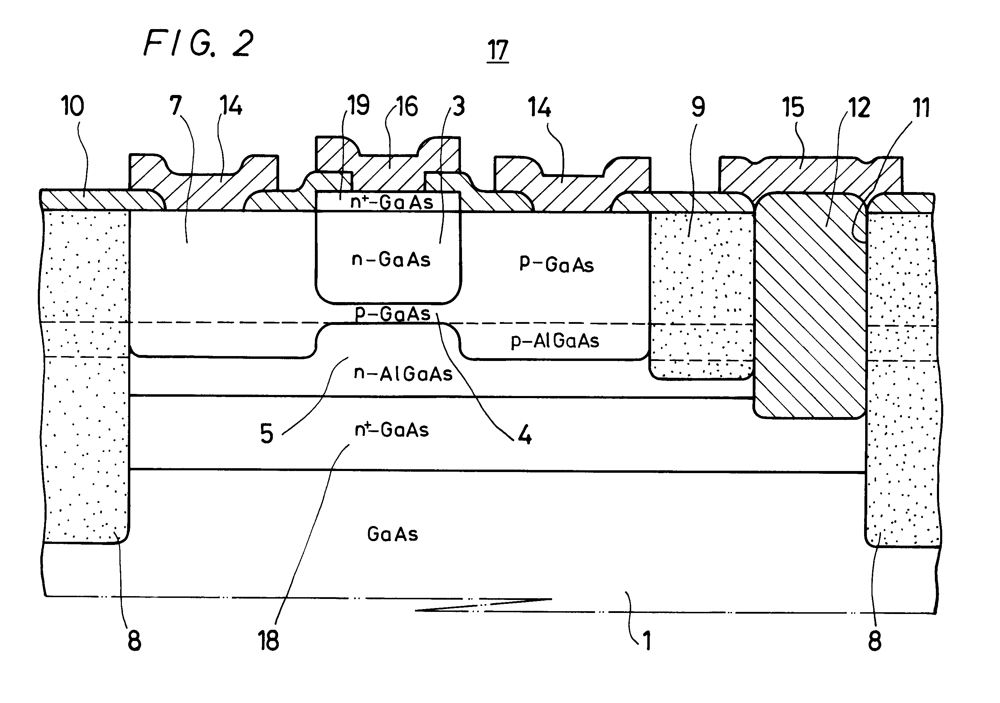

Figure 2 of the accompanying drawings shows a previously proposed so-called collector top type HJBT 17 in which a collector region is formed at its surface side. The process for manufacturing the collector top HJBT 17 is substantially the same as that for manufacturing the HJBT 13, which is a so-called emitter top type HJBT, except for the sequential order of the epitaxial growth. In Figure 2, parts corresponding to like parts of Figure 1 are designated by the same references. The HJBT 17 shown in Figure 2 comprises an $n^+$-GaAs layer 18 which will become an emitter electrode deriving layer, an n-AlGaAs layer 5 which will become an emitter region, a p-GaAs layer 4 which will become a base region, an n-GaAs layer 3 which will become a collector region, an $n^+$-GaAs layer 19 which will become a collector cap layer, and an external base region 7.

The switching time $\tau s$ of an HJBT is given by the equation

$$\tau s = (5/2) \, Rb \, Cc + (Rb/RL) \, \tau b + (3Cc + CL) \cdot R_L,$$

where Rb represents the base resistance, Cc the capacitance between the base and the collector, RL the load resistance, CL the load capacitance and $\tau b$ the base transit time. Therefore, to reduce the switching time $\tau s$, the base resistance Rb and the capacitance Cc between the base and the collector must be reduced. In general, since the collector top type HJBT is more advantageous for reducing the capacitance Cc than the emitter top type HJBT, the former is considered to be capable of operating at a speed higher than the latter. The reason for this is as follows.

(i) Since the collector top type HJBT is small in collector dimension, the collector to base junction capacitance is reduced. This advantage permits high speed operation of the HJBT. Conversely, the emitter dimension thereof is increased so that the emitter to base capacitance is increased. Although this is not a merit of the collector top type HJBT, since the contact between the emitter and the base is the heterojunction, the capacitance therebetween becomes smaller than that of a homojunction. Further, since the emitter concentration is small, the emitter junction capacitance can be reduced originally, causing no trouble. The collector top type HJBT can provide many more advantages by reduction of the collector capacitance and it can operate at a higher speed of operation according to demonstrated simulation results.

(ii) In regard to the circuitry, in the case of emitter-coupled-logic (ECL), the emitters of some transistors are commonly coupled to form a gate so that the element dimensions can be reduced by making the $n^+$ emitter layers common, without isolation.

In the above-described previously proposed HJBTs, if the dimensions of the device are made smaller, the capacitance at the periphery of the active region, that is the capacitances at the peripheries between the collector and the external base and between the emitter and the external base, are relatively increased. For example, in the collector top type HJBT shown in Figure 2, calculating the capacitance where the collector dimension is $1 \times 1\mu m^2$, the intrinsic capacitance is small such that the emitter to base capacitance Ceb is approximately equal to 2.7 fF and the collector to base capacitance Cbc is approximately 0.27 fF (assuming the thickness of the depletion layer is 400 nm (4000 Angstroms)). However, the extrinsic capacitance, that is capacitances Ceb′ and Cbc′ produced only at the peripheries, are very large: Ceb′ is approximately equal to 3.2 fF and Cbc′ is approximately equal to 0.5 fF. Thus, it is desirable that an HJBT be constructed so as to suppress the capacitance at the peripheral portion as the dimensions of the device are reduced. In practice, silicon bipolar transistors are constructed in this way, see e.g. EP-A-0 039 015.

In the HJBT shown, for example, in Figure 2, if the external capacitance is reduced, the base contact region is reduced so that the base contact resistance is increased, thus restricting the speed of operation of the element.

In addition to the above-mentioned defects, the previously proposed HJBT with the external base formed by ion implantation has the following defects.

(a) The concentration of the external base region cannot be increased.

(b) The junction position is displaced by the diffusion of injected impurity into the emitter region and the diffusion of impurity into the intrinsic base region, upon annealing for activation.

(c) As the dimensions of the device are reduced, the external capacitances at peripheries produced between the emitter and the external base and between the collector and the external base are relatively increased. In particular, the collector capacitance at the periphery cannot be removed.

(d) The techniques of forming a deep trench and burying a metal must be adopted for deriving the collector (or emitter) electrode.

(e) The contact dimension between the base and the emitter cannot be increased without increasing the capacitance.

(f) Of the electrons injected from the emitter region into the intrinsic base region, the electrons at the periphery are diffused into the external base region by a diffusing length (several micrometres) and recombined with holes to become a base current, thus causing a so-called periphery effect. Thus, when the element is reduced in size, the current gain is lowered.

(g) There is a limit to reduction of the intrinsic region.

According to various aspects thereof defined by the claims, the invention provides HJBTs, a method of manufacturing an HJBT, and semiconductor integrated circuits comprising HJBTs.

Preferred embodiments of the invention described hereinbelow seek to provide the following:

(i) An improved HJBT and a manufacturing method therefor.

(ii) An HJBT with a small collector capacitance, a small emitter capacitance and a small base contact resistance, and which can operate at higher speed and which can be formed into an integrated circuit (IC) with ease; and a manufacturing method therefor.

(iii) An HJBT which can operate at higher operational speed, which can be formed into an IC with ease, and which can prevent leakage current from being produced; and a manufacturing method therefor.

(iv) An HJBT of a reduced intrinsic region which can be fabricated as an integrated circuit and which can operate at higher operational speed; and a manufacturing method therefor.

(v) Collector top and emitter top type HJBTs with a small collector capacitance and a small emitter capacitance, and which can be operated at higher speed and fabricated as an integrated circuit, and semiconductor ICs including such HJBTs and a load resistor.

The invention will now be further described, by way of illustrative and non-limiting example, with reference to the accompanying drawings, in which like references identify the same or similar parts throughout, and in which:

Figure 1 is a cross-sectional view of a previously proposed emitter top type heterojunction bipolar transistor (HJBT);

Figure 2 is a cross-sectional view of a previously proposed collector top type HJBT;

Figures 3A to 3F are respective cross-sectional views of a collector top type HJBT embodying the invention and illustrate sequential steps of a method of manufacturing the HJBT;

Figures 3G and 3H are plan views corresponding to Figures 3E and 3F, respectively;

Figures 4A to 4H are respective cross-sectional views of another collector top type HJBT embodying the invention and illustrate sequential steps of a method of manufacturing the HJBT;

Figure 4I is a plan view corresponding to Figure 4H;

Figures 5A to 5G are respective cross-sectional views of an emitter top type HJBT embodying the invention and illustrate sequential steps of a method of manufacturing the HJBT;

Figure 5H is a plan view corresponding to Figure 5G;

Figures 6A, 6C and 6E are respective cross-sectional views of a further collector top type HJBT embodying the invention and illustrate sequential steps of a method of manufacturing the HJBT;

Figures 6B, 6D and 6F are plan views corresponding to Figures 6A, 6C and 6E, respectively;

Figure 7 is a plan view illustrating an example of a memory cell which utilises an HJBT embodying the invention;

Figure 8 is a cross-sectional view taken along a line A - A in Figure 7;

Figure 9 is a cross-sectional view taken along a line B - B in Figure 7;

Figure 10 is a diagram showing an equivalent circuit of Figure 7;

Figure 11 is a plan view of an example of a semiconductor integrated circuit comprising two gates, each comprising 3-input NOR and OR circuits, which utilise collector top type HJBTs embodying the invention;

Figure 12 is a diagram showing an equivalent circuit of an upper half portion of Figure 11;

Figure 13 is a plan view of an example of a semiconductor integrated circuit comprising two gates, each comprising 3-input NOR and OR circuits, which utilise emitter top type HJBTs embodying the invention; and

Figure 14 is a diagram showing an equivalent circuit of an upper half portion of Figure 13.

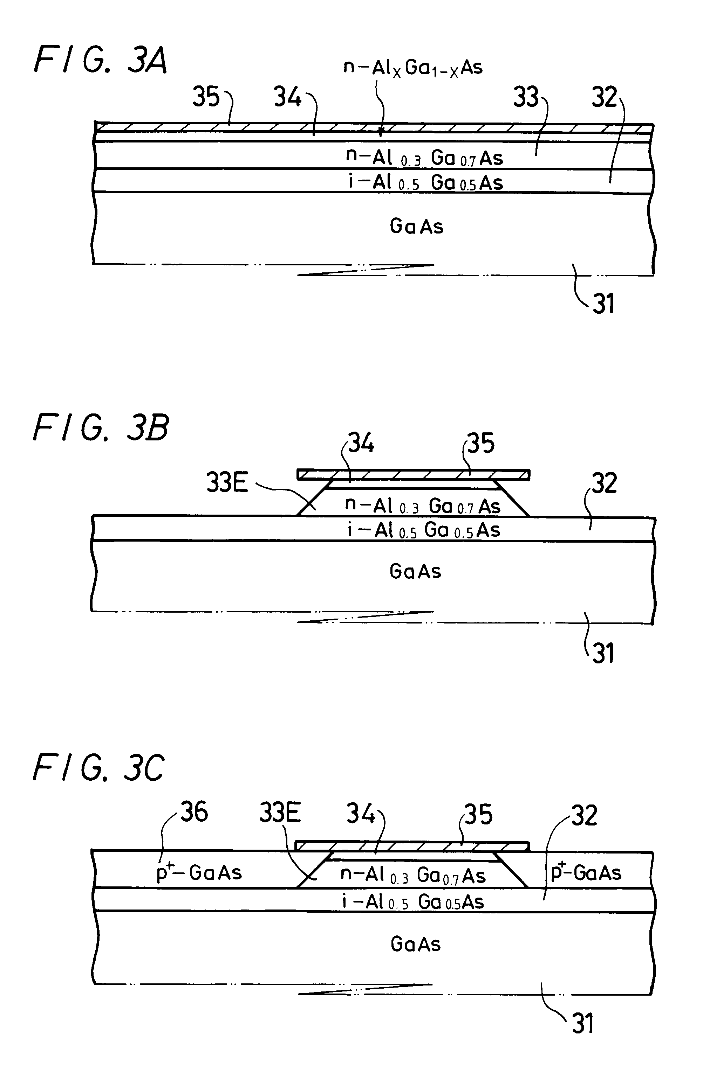

A collector-top type heterojunction bipolar transistor (HJBT) embodying the invention and a method of manufacturing the HJBT will now be described with reference to Figures 3A to 3H.

As shown in Figure 3A, the following layers are sequentially grown on a semi-insulating GaAs substrate 31 according to the metal organic chemical vapour deposition (MOCVD) method: a wide band gap layer having high resistance which will become a barrier layer 32 for an emitter, that is, a semi-insulating 0.3 micrometre thick $i$-$Al_{0.5}Ga_{0.5}As$ (undoped) layer; an Si-doped 0.5 micrometre thick $n$-$Al_{0.3}Ga_{0.7}As$ layer 33 having an impurity concentration of about $2 \times 10^{18}$ cm$^{-3}$, which will become an emitter region; and an inclined composition layer 34 formed by sequentially changing the Al composition ratio $x$ in $n$-$Al_xGa_{1-x}As$ from 0.3 to 0. The layer 34 has a thickness of 0.03 micrometres and an impurity concentration of about $5 \times 10^{17}$ cm$^{-3}$. The layer 34 is formed in such a manner that the ratio $x$ is gradually changed from 0.3 to 0 in the direction from its bottom to its top as viewed in Figure 3A. A silicon nitride ($Si_3N_4$) layer 35 having a thickness of 0.1 micrometres is deposited on the inclined composition layer 34.

Then, as shown in Figure 3B, the silicon nitride layer 35 is selectively etched away so as to leave a portion thereof corresponding to the emitter region. Thereafter, the remaining silicon nitride layer 35 is used as a mask layer to carry out wet etching by which the inclined composition layer 34 and the $n$-$Al_{0.3}Ga_{0.7}As$ layer 33 are selectively etched away to form an emitter region 33E.

Next, as shown in Figure 3C, by employing the remaining silicon nitride layer 35 as a mask layer a $p^+$-GaAs layer 36 which will become an external base region is selectively grown to a height which is the same as that of the under surface of the layer 35.

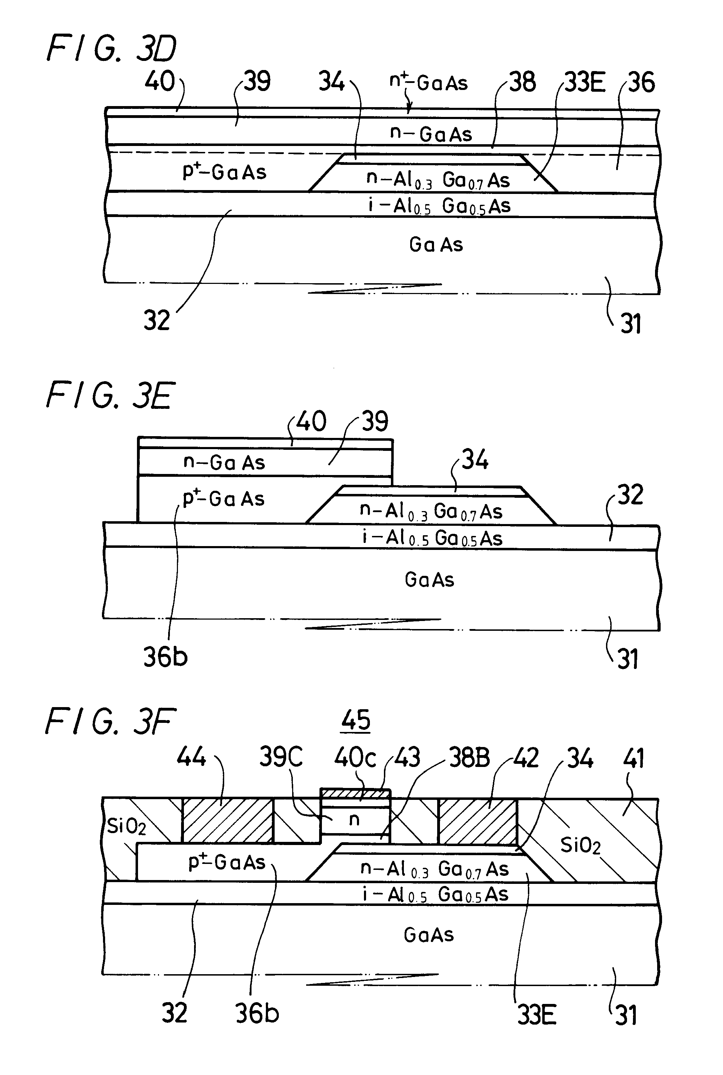

Then, as shown in Figure 3D, after removal of the silicon nitride layer 35, the following layers are sequentially grown by an MOCVD method: an undoped GaAs 0.01 micrometre thick spacer layer (not shown); a 0.1 micrometre thick $p^+$-GaAs layer 38 having an impurity concentration of about $2 \times 10^{19}$ cm$^{-3}$, which will become an intrinsic base region; a 0.4 micrometre thick $n$-GaAs layer 39 having an impurity concentration of about $10^{17}$ cm$^{-3}$, which will become a collector region; and a 0.1 micrometre thick $n^+$-GaAs layer 40 having an impurity concentration of about $5 \times 10^{18}$ cm$^{-3}$, which will become a collector cap layer. The undoped GaAs spacer layer is effective to prevent the p-type impurity (for example Zn) of the $p^+$-GaAs layer 38 from being diffused into the n-AlGaAs emitter region 33E.

As shown in Figure 3E, the $n^+$-GaAs layer 40, the $n$-GaAs layer 39 and the $p^+$-GaAs layers 38 and 36 are selectively etched away according to the reactive ion etching (RIE) process, leaving the portions corresponding to the collector region and the external base region. Thus, an external base region 36b is formed. Since the AlGaAs layer is not etched away by the RIE process, exposure of the surface of the inclined composition layer 34 forming a part of the emitter region and isolation between the elements are carried out by the RIE process.

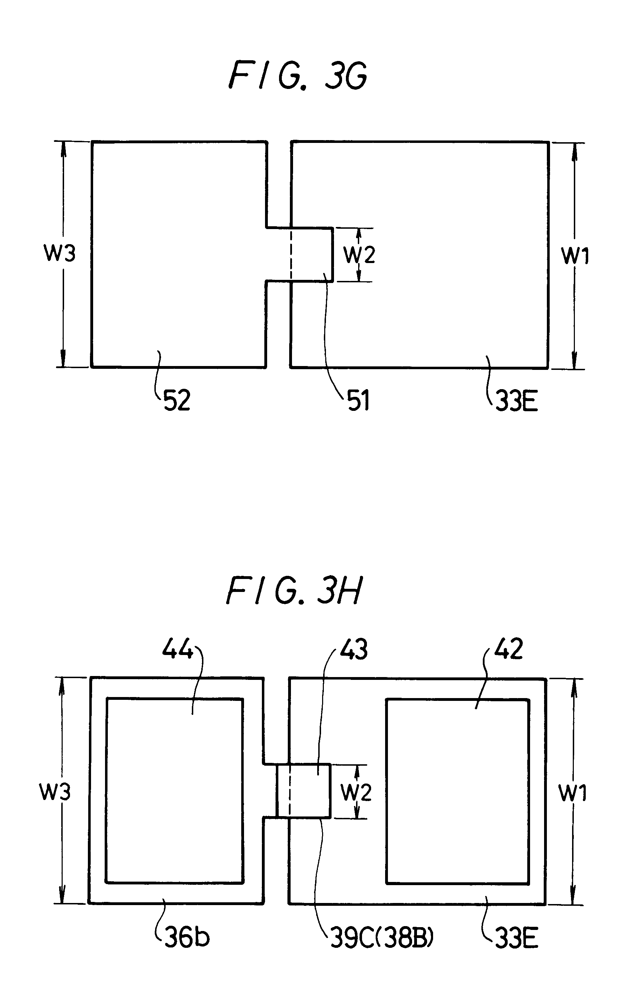

The selective etching pattern is made to be shown in Figure 3G as viewed in plan. Specifically, the selective etching process is carried out such that the pattern includes, as shown in Figure 3G, a region 51 (corresponding to the dimension of an intrinsic portion which will be described later) overlapping a central portion of one edge of the square-shaped emitter region 33E and having a width W2 smaller than the width W1 of the emitter region 33E, and a region 52 (corresponding to the dimension of an external base region which will be described later) coupled to a portion of the region 51 extending outside of the emitter region 33E and having a width W3 (W1 = W3 in the illustrated example) greater than the width W2 of the region 51.

Then, the $n^+$-GaAs layer 40, n-GaAs layer 39 and the $p^+$-GaAs layer 38 on the external base region 36b are selectively removed by the RIE process to form a collector cap layer 40c, a collector region 39C and an intrinsic base region 38B. Then, a silicon oxide ($SiO_2$) layer 41 is formed on the whole surface, made flat and made level with the surface of the collector cap layer 40c. Thereafter, windows for deriving a base electrode and an emitter electrode are formed through the silicon oxide layer 41, for the n-AlGaAs emitter region, i.e. the inclined composition layer 34 on the surface thereof and for the $n^+$-GaAs capping layer 40c, and an AuGe/Au emitter electrode 42 and a collector electrode 43 are formed. Also, a Ti/Pt/Au base electrode 44 is formed on the $p^+$-GaAs external base region 36b. Thus, as shown in Figures 3F and 3H, the external base region 36b and the emitter region 33E are formed in contact with each other at one side surface of each and, under the external base region 36b and the emitter region 33E, there is formed the semi-insulating AlGaAs barrier layer 32. On one portion of the emitter region 33E, there are formed the intrinsic base region 38B and the collector region 39C having the width W2 smaller than the width W3 of the external base region 36B and the width W1 of the emitter region 33E so as to include the boundary between the emitter region 33E and the external base region 36b, that is so as to come in contact with the external base region 36b in part. Therefore, the external base region 36b and the intrinsic base region 38B are brought into contact with each other at one edge, thus producing a collector top type HJBT 45 in which the width W2 of the intrinsic base region 38B is selected to be smaller than the width W3 of the external base region 36b.

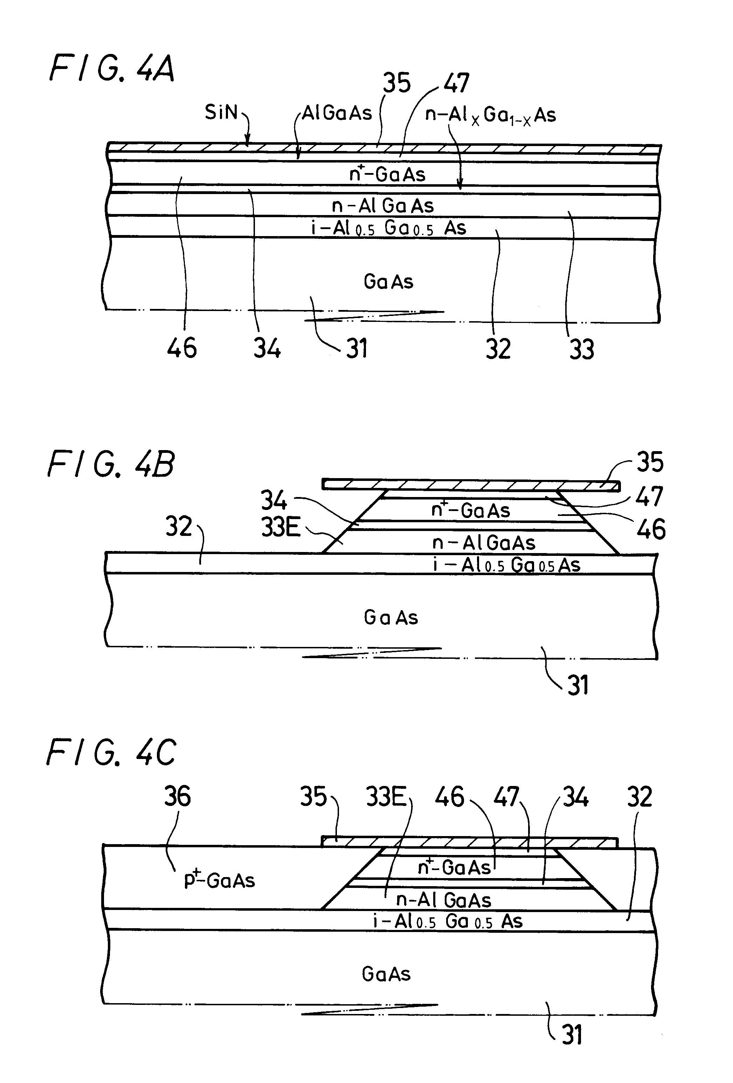

Figures 4A to 4I illustrate another collector top type HJBT embodying the invention.

As shown in Figure 4A the following layers are sequentially deposited by the MOCVD process on a semi-insulating GaAs substrate 31: a semi-insulating 0.3 micrometre thick $Al_{0.5}Ga_{0.5}As$ (undoped) layer 32 which will become a barrier layer relative to the emitter; an Si-doped 0.5 micrometre thick n-$Al_{0.3}Ga_{0.7}As$ layer 33 having an impurity concentration of about 2 x $10^{18}$ cm$^{-3}$, which will become an emitter region; a 0.03 micrometre thick inclined composition layer 34 having an impurity concentration of about 5 x $10^{17}$ cm$^{-3}$ and formed by sequentially changing the composition ratio x of an n $Al_xGa_{1-x}As$ layer; a 0.5 micrometre thick $\overline{n}^+$-GaAs layer 46 having an impurity concentration of about 5 x $10^{18}$ cm$^{-3}$, which will be-

come an emitter cap layer; and a 0.02 micrometre thick n-$Al_{0.3}Ga_{0.7}As$ layer 47 having an impurity concentration of about 5 x $10^{18}$ cm$^{-3}$. A 0.1 micrometre thick silicon nitride (SiN) layer 35 is formed on the n-$Al_{0.3}Ga_{0.7}As$ layer 47.

Then, as shown in Figure 4B, the silicon nitride layer 35 is selectively etched away to leave a portion thereof corresponding to the emitter region. Then, the remaining silicon nitride layer 35 is employed as a mask layer to selectively etch and remove the layers 47, 46, 34, and 33 to form an emitter region 33E.

Next, as shown in Figure 4C, by employing the silicon nitride layer 35 as a mask, a $p^+$-GaAs layer 36 which will become an external base region is selectively grown to a height up to the under surface of the layer 35.

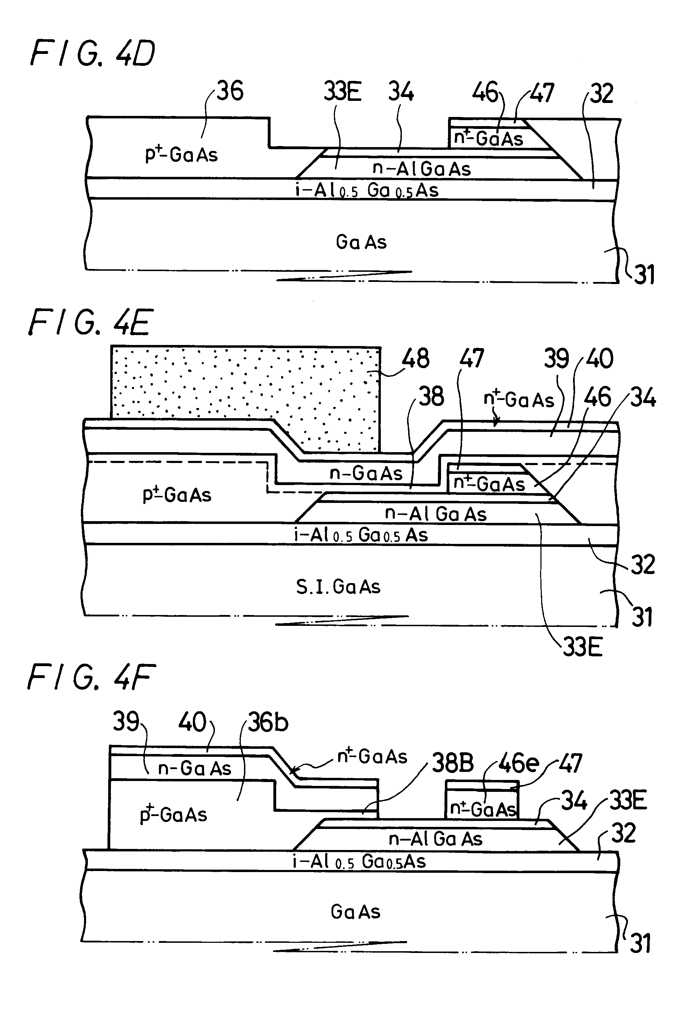

As shown in Figure 4D, after removal of the silicon nitride layer 35, a portion of the n-$Al_{0.3}Ga_{0.7}As$ layer 47 containing a portion corresponding to a collector region is removed by a wet etching process. Subsequently, according to the RIE process, portions of the $n^+$-GaAs layer 46 and the $p^+$-GaAs layer 36 including the boundary between the layers 36 and 46 are selectively etched and removed in an amount corresponding to the thickness of the layer 46.

Then, as shown in Figure 4E, the following layers are sequentially grown by the MOCVD method: a 0.01 micrometre thick undoped GaAs spacer layer (not shown); a 0.1 micrometre thick $p^+$-GaAs layer 38 having an impurity concentration of about 2 x $10^{19}$ cm$^{-3}$, which will become an intrinsic base region; a 0.4 micrometre thick $n^+$-GaAs layer 39 having an impurity concentration of about $10^{17}$ cm$^{-3}$, which will become a collector region; and a 0.1 micrometre thick $n^+$-GaAs layer 40 having an impurity concentration of about 5 x $10^{18}$ cm$^{-3}$, which will become a collector capping layer.

As shown in Figure 4F, with the employment of a mask 48 (refer to Figure 4E), the $n^+$-GaAs layer 40, the n-GaAs layer 39 and the $p^+$-GaAs layer 36 are selectively etched away by the RIE process to leave portions corresponding to the collector region and the external base region. Thus, an external base region 36b and an emitter capping layer 46e are formed. At that time, the AlGaAs layer is not etched by the RIE process. Therefore, since the AlGaAs layer 47 is formed on the emitter capping layer 46e, the emitter capping layer 46e is not etched away.

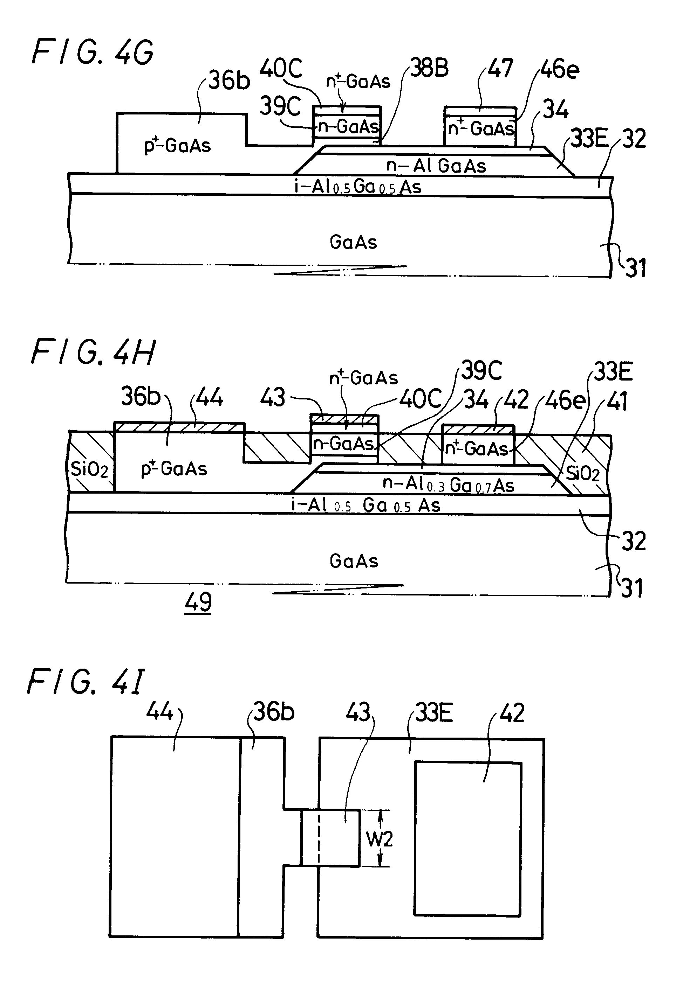

As shown in Figure 4G, the $n^+$-GaAs layer 40 and the n-GaAs layer 39 on the external base region 36b are selectively etched away. Thus, a collector capping layer 40c, a collector region 39C and an intrinsic base region 38B are formed.

Next, employing the chemical vapour deposition (CVD) process, as shown in Figure 4H, a silicon oxide (SiO$_2$) layer 41 is deposited on the whole surface and then made flat, whereby surfaces of the external base region 36b, the collector capping layer 40c and the emitter capping layer 46e are exposed. Thereafter, an AuGe/Au collector electrode 43 and an AuGe/Au emitter electrode 42 are formed on the collector capping layer 40c and the emitter capping layer 46e, respectively. Further, a Ti/Pt/Au base electrode 44 is formed on the external base region 36b so as thereby to form a desired collector top type HJBT 49 as shown in Figure 4H. Figure 4I is a plan view of the HJBT 49.

The thus-formed collector top type HJBT has the following advantages.

Since the collector region 39C is formed to be of mesa-type and the side surface thereof is covered by the silicon oxide layer 41, collector capacitance is not produced at the periphery and only the intrinsic collector capacitance constitutes the collector capacitance. Thus, the collector capacitance becomes extremely small.

Since the external base region 36b is formed of an expitaxial layer having a thickness of 0.5 micrometres and an impurity concentration of more than $2 \times 10^{19}$ cm$^{-3}$, the impurity concentration thereof can be improved by about one order as compared with the previously proposed case in which the external base region is formed by ion implantation on an n-AlGaAs layer and, also, the mobility thereof can be increased. Thus, the external base resistance thereof can be decreased. In order to reduce the base contact resistance, it is sufficient to increase the contact dimension in addition to increasing the impurity concentration at the external base region 36b. In an HJBT of the previously proposed structure, this increase of the impurity concentration causes the collector capacitance to be increased. However, according to the structure of the present embodiment, since the external base region 36b does not substantially contact the collector region 39C and contacts the emitter region 33E only at its one side surface having the width W2, the dimension of the external base region 36b can be increased without increasing the external capacitance, whereby the base contact resistance is decreased.

As shown in Figures 4G and 4I, the emitter region 33E and the external base region 36b contact each other in the range of the width W2 at one side surface so that the emitter capacitance can be decreased.

According to the above-described embodiments of the present invention, as the dimensions of the device are reduced the capacitances produced between the emitter and the external base and between the collector and the external base are prevented from being increased relatively. In addition, the base contact resistance thereof can be decreased, so that the above-described HJBTs can be operated at high speed and can be fabricated into a integrated circuit (IC) with ease.

Since the present HJBT is formed such that the emitter region 33E and the external base region 36b contact each other only at one edge, electrons injected from the emitter region 33E into the intrinsic base region 38B can be less diffused into the external base region 36b. This means that the loss of electrons at the periphery can be decreased (that is, the so-called periphery effect can be decreased in principle). Thus, even when the dimensions of the active region are reduced to be as small as $1 \times 1\mu$m$^2$, high current gain can be achieved in the low current region.

Since the semi-insulating AlGaAs barrier layer 32 having the wide gap is formed between the semi-insulating GaAs substrate 31 and both the emitter region 33E and the external base region 36b, it is possible to prevent current from leaking through the substrate 31 between the p$^+$-GaAs external base region 36b and the n-AlGaAs emitter region 33E.

Further, since the n-Al$_x$Ga$_{l-x}$As inclined composition layer 34 is provided between the emitter region 33E and the intrinsic base region 38B, the mobility of the electrons can be improved and therefore, a so-called emitter current can flow with ease

According to the above-described structure, since the base, collector and emitter are substantially formed as a planar structure (a structure in which the electrodes are provided on the upper surface), the trench used in the previous proposals for deriving the emitter electrode or the collector electrode becomes unnecessary. Also, the elements can be automatically isolated as the collector region is formed by the RIE process. In addition, the ion implantation technique and the annealing technique are not required so that the reproducibility of the elements can be enhanced.

Further, after the thick external base region 36b has been formed, the intrinsic base region 38B is formed by the final epitaxial growth operation. Therefore, the thickness of the intrinsic base region 38B can be reduced as much as possible and, for example, the intrinsic base region 38B can be formed to have a thickness ranging from 20 to 30 nm (200 to 300 Angstroms) with excellent accuracy. At the same time, no junction displacement is produced. Further, a load resistor can easily be realised by the n-AlGaAs layer 33 forming the emitter region 33E or the p$^+$-GaAs layer 36 forming the external base region 36b.

Common mode logic (CML) is generally known as providing high speed bipolar circuitry. With the collector top type HJBT structure embodying the invention, one emitter can be made common to plural transistors, thus making it possible to fabricate the CML structure with ease. For example, in the case of two gates each comprising 3-input NOR and OR gate circuits (not shown), load resistors can be integrally formed as a unitary structure in the AlGaAs layer which forms, for example, the emitter region. According to this structure, as compared with the previously proposed emitter top type HJBT, a long lead wire does not have to be laid around so that the structure thereof can be simplified.

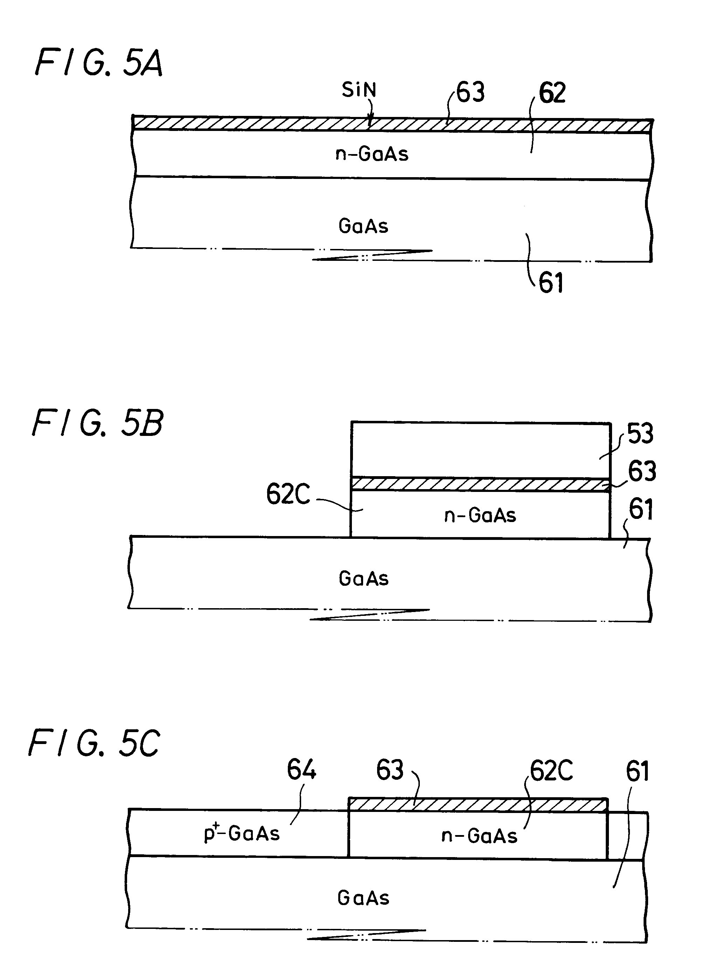

Figure 5A to 5H illustrate an emitter top type HJBT embodying the invention.

As shown in Figure 5A, a 0.6 micrometre thick n-GaAs layer 62 having an impurity concentration in the order of about $10^{17}$ cm$^{-3}$, and which will become a collector region, is grown on a semi-insulating GaAs substrate 61 by the MOCVD method. Further, a 0.1 micrometre thick silicon nitride layer 63 is deposited on the n-GaAs layer 62 by the CVD method.

Then, as shown in Figure 5B, with a photoresist layer 53 employed as a mask, parts of the silicon nitride layer 63 and the n-GaAs layer 62 other than those beneath the mask are selectively etched away by the RIE process while leaving their portions corresponding to the collector region, thus forming a collector region 62C.

Next, as shown in Figure 5C, using the remaining-silicon nitride layer 63 as a mask, a 0.6 micrometre thick p$^+$-GaAs layer 64 having an impurity concentration of about 2 x $10^{19}$ cm$^{-3}$, and which will become an external base region, is selectively grown to have a thickness substantially the same as that of the collector region 62C.

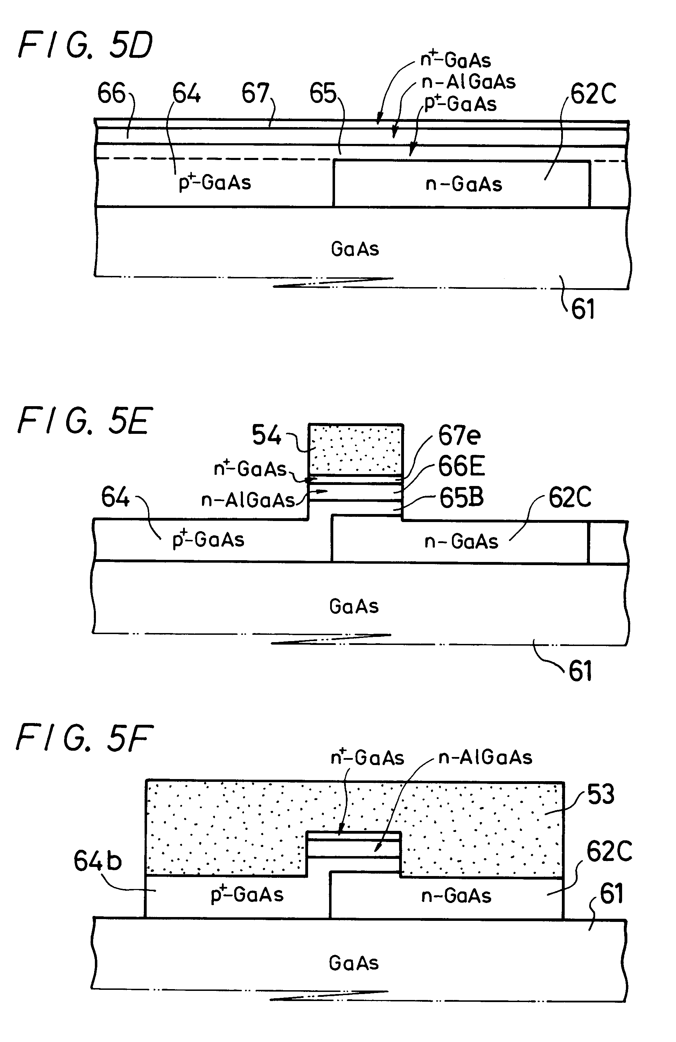

Then, as shown in Figure 5D, the silicon nitride layer 63 is removed by HF solution. Thereafter, the following layers are sequentially grown on the collector region 62C and the p$^+$-GaAs layer 64: a 0.05 micrometre thick p$^+$-GaAs layer 65 having an impurity concentration of about 2 x $10^{19}$ cm$^{-3}$, which will become an intrinsic base region; a 0.15 micrometre thick undoped GaAs spacer layer (not shown); a 0.15 micrometre thick n-Al$_{0.3}$Ga$_{0.7}$As layer 66 having an impurity concentration of about 5 x $10^{17}$ cm$^{-3}$, which will become an emitter region; and a 0.05 micrometre thick n$^+$-GaAs layer 67 having an impurity concentration of about 5 x $10^{18}$ cm$^{-3}$, which will become a capping layer for the emitter.

Then, as shown in Figure 5E, the portion corresponding to the emitter region is masked by a photoresist layer 54 and etching by the reactive ion beam etching (RIBE) process is carried out to a depth of 0.4 micrometres. In other words, the n$^+$-GaAs layer 67, the n-AlGaAs layer 66, the p$^+$-GaAs layer 65 and the p$^+$-GaAs layer 64 which will become the external base region are selectively etched so as to reach a part of the collector region 62C, whereby the surface of the layer 64 and the surface of the collector region 62C are exposed to the outside. Thus, an emitter capping layer 67e, an emitter region 66E and an intrinsic base region 65B are formed. If no RIBE apparatus is available, the above process can be performed by the wet etching process.

Next, as shown in Figure 5F, a photoresist layer 53 is used to mask the element regions and etching is carried out to remove unnecessary portions up to the substrate 61 for isolating the elements, thus forming an external base region 64b.

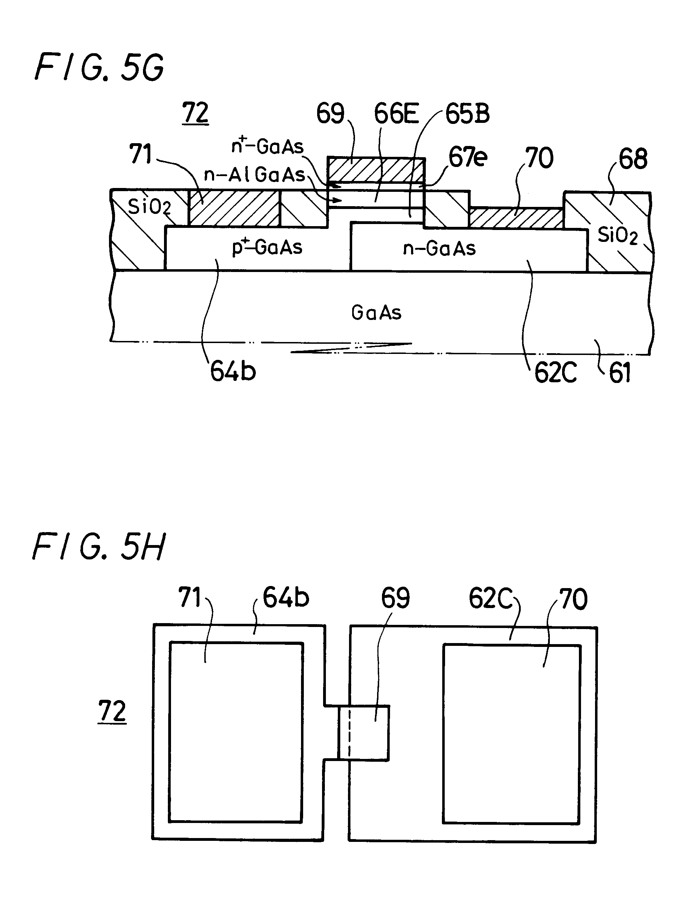

Then, as shown in Figure 5G, a silicon oxide (SiO$_2$) layer 68 is formed on the upper surface and made flat. Thereafter, windows are formed through the silicon oxide layer 68 to derive a base electrode and a collector electrode. An emitter electrode 69 and a collector electrode 70, each of AuGe/Au, are formed through the windows on the emitter capping layer 67e and the collector region 62C, which are then annealed at 450°C for 10 seconds. Thereafter, a base electrode 71 of Ti/Pt/Au is formed on the external base region 64b, thus forming a desired emitter top type HJBT 72.

Figure 5H is a plan view of the HJBT 72. In this case, if an n$^+$-GaAs layer is buried beneath the n-GaAs collector region 62C, the value of the resistance between the intrinsic collector region and the external collector region is reduced and hence an effect is attained. This n-GaAs layer may be formed by ion implantation of Si before the first epitaxial growth operation.

In the emitter top type HJBT 72, the external base region 64b and the collector region 62C contact each other only at one edge, in similar manner to that described above. Further, since the external base region 64b and the emitter region 66E are not substantially in contact with each other, the collector capacitance and the emitter capacitance can be reduced. Furthermore, the external base resistance can be decreased and, without increasing the collector capacitance, the base contact resistance can be reduced. Further, since the intrinsic base region is made by the final epitaxial growth operation, the thickness of the intrinsic base region can be reduced to its limit and no positional displacement is produced in the junction. Since element isolation is performed by the etching process described with reference to Figure 5F, the previously proposed ion implantation technique and annealing technique become unnecessary. A load resistor can easily be realised by the n-GaAs layer 62 forming the collector region 62C and the p$^+$-GaAs layer 64 forming the external base region 64b.

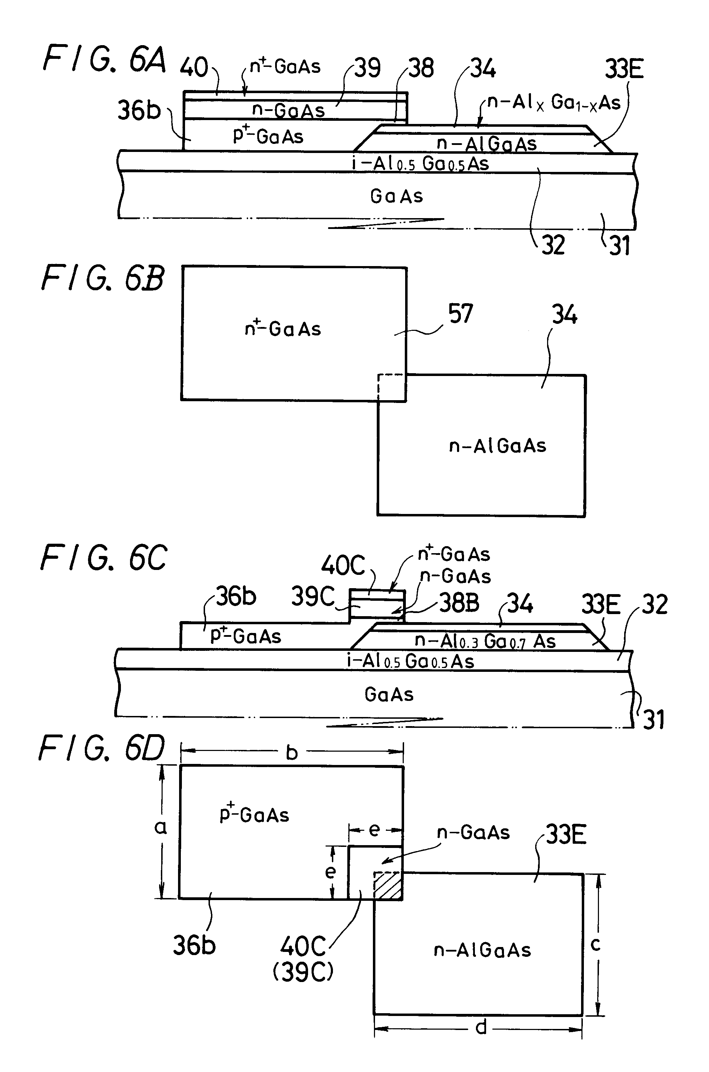

Figures 6A to 6F illustrate a further collector top type HJBT embodying the invention. In this embodiment, subsequent to the process step described with reference to Figure 3D, the n$^+$-GaAs layer 40, the n-GaAs layer 39 and the p$^+$-GaAs layers 38 and 36 are selectively etched away by the RIE process, as shown in Figures 6A and 6B, to form a region 57 which corresponds to the collector region and the external base region. At that time, the region 57 overlaps with the underlying emitter region 33E only at one corner portion, as shown in Figure 6B. Then, as shown in Figures 6C and 6D, a mask (not shown) is used to cover the overlapped portion, whereby, using the RIE process, the n$^+$-GaAs layer 40, the n-GaAs layer 39 and the p$^+$-GaAs layer 38 are selectively etched away to form the collector capping layer 40C, the collector region 39C and the intrinsic base region 38B, all of which form parts of a common external surface with the external base region 36b.

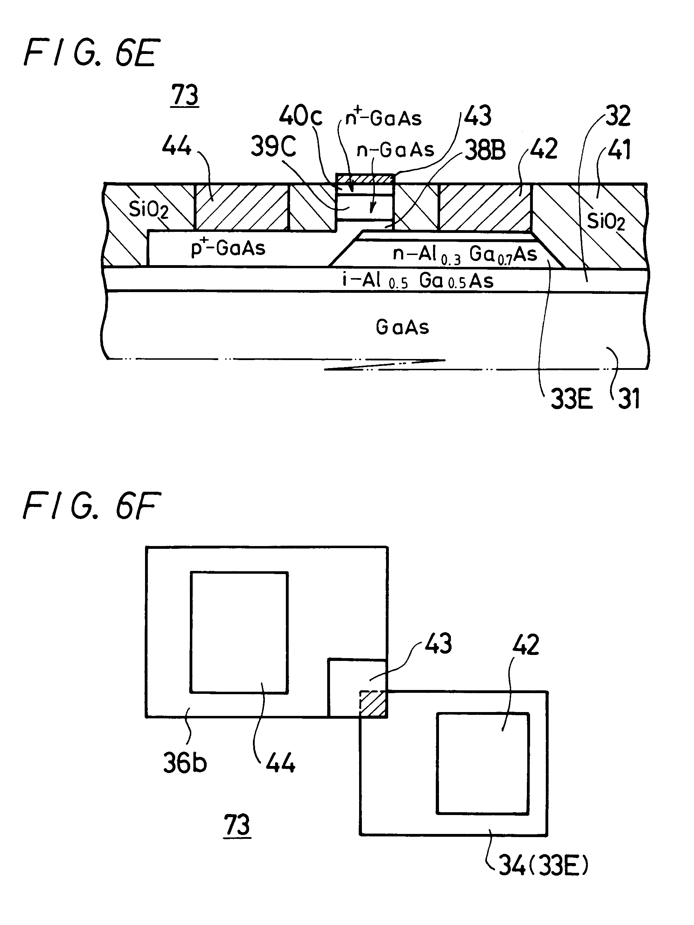

It is possible, for example, that: the external base region 36b has a longitudinal length a = 3 micrometres and a lateral length b = 5 micrometres; the emitter region 33E has a longitudinal length c = 3 micrometres and a lateral length d = 3 micrometres; and the collector region 39c has longitudinal and lateral lengths e = 1.5 micrometres. Accordingly, the length of the intrinsic region (hatched portion in Figure 6D) is in the order of sub-micrometres. Thereafter, as shown in Figures 6E and 6F, a silicon oxide layer 41 is formed on the whole surface and made flat and to have its surface level with the surface of the collector capping layer 40c. Windows are then formed through the silicon oxide layer 41 and then an emitter electrode 42 and a collector electrode 43, each of AuGe/Au, are formed on the inclined composition layer 34 and the capping layer 40c, respectively. Further, a base electrode 44 of Ti/Pt/Au is formed on the external base region 36b, whereby a desired collector top type HJBT 73 is obtained. According to this collector top type HJBT 73, the widths of, in particular, the intrinsic collector region and the intrinsic emitter region can be made smaller than the minimum line width.

While in Figure 6 the invention is applied to a collector top type HJBT, the invention can similarly be applied to an emitter top type HJBT by utilising the techniques described with reference to Figures 5A to 5H.

While in the above-described embodiments the invention is applied to HJBTs of the AlGaAs/GaAs system, the invention can also be applied to HJBTs of other systems, for example the GaAs/InGaAs system. With the GaAs (emitter)/InGaAs (base)-/GaAs(collector) structure, the invention can be applied to both collector top type and emitter top type HJBTs.

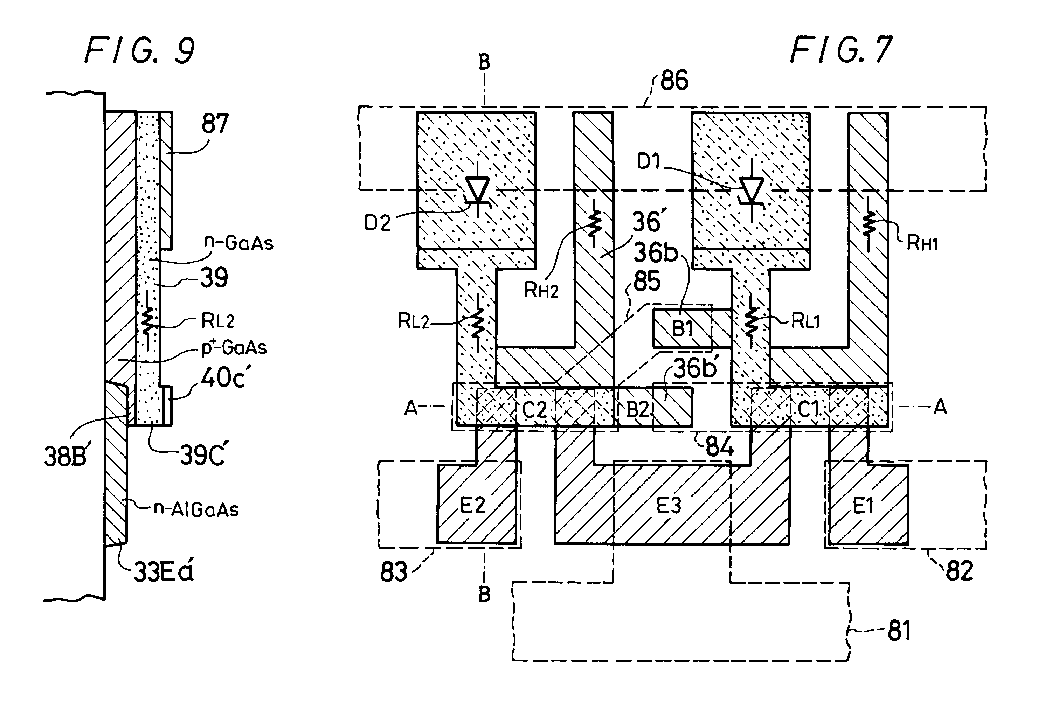

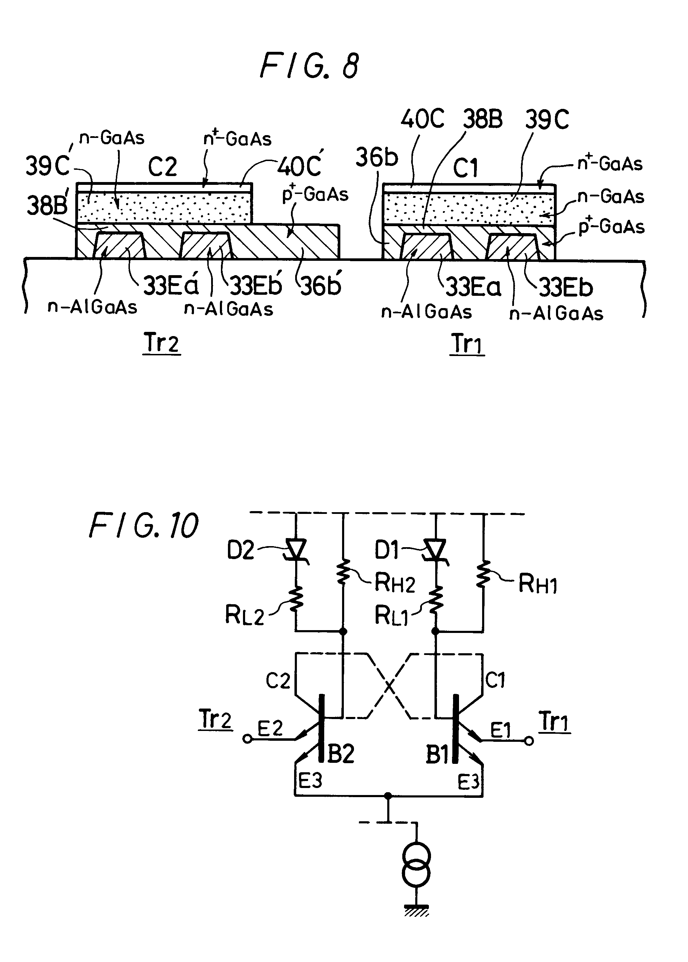

Figure 7 is a plan view of an example of a memory cell using the collector top type HJBT embodying the invention. Figure 8 is a cross-sectional view taken along a line A - A in Figure 7 and Figure 9 is a cross-sectional view taken along a line B - B in Figure 7. Figure 10 is a diagram showing an equivalent circuit of the memory cell. Throughout the figures, Tr1 and Tr2 designate first and second HJBTs, respectively.

As illustrated in Figures 7 and 8, the first HJBT Tr1 comprises first and second emitter regions 33Ea and 33Eb (that is, emitters E1 and E3) each formed of the n-AlGaAs layer, an intrinsic base region 38B (that is, a base B1) formed of the p$^+$-GaAs layer, and a collector region 39C (that is, a collector C1) formed of the n-GaAs layer. In like manner, the second HJBT Tr2 comprises first and second emitter regions 33Ea$'$ and 33Eb$'$ (that is, emitters E2 and E3) each of which is formed of the n-AlGaAs layer, an intrinsic base region 38B$'$ (that is, a base B2) formed of the p$^+$-GaAs layer, and a collector region 39C$'$ (that is, a collector C2) formed of the n-GaAs layer. Reference numerals 40C and 40C$'$ depict collector capping layers formed of the n$^+$-GaAs layer and 36b and 36b$'$ external base regions formed of the p$^+$-GaAs layer. The second emitters E3 and E3 of the HJBTs Tr1 and Tr2 are commonly connected through the n-AlGaAs layer which forms the emitter region. A word line 81 (shown in phantom in Figure 7), fabricated by wiring of the electrodes, is connected to the portion in which the second emitters E3, E3 are connected. Bit lines 82 and 83 (shown in phantom), each of which is formed by wiring of the electrodes, are connected to the first emitter E1 of the first HJBT Tr1 and the second emitter E2 of the second HJBT Tr2. The collector C1 of the first HJBT Tr1 and the base B2 of the second HJBT Tr2 are commonly connected by electrode wiring 84 (shown in phantom). The base B1 of the first HJBT Tr1 and the collector C2 of the second HJBT Tr2 are connected to each other by electrode wiring 85 (shown in phantom). The base B1 of the first HJBT Tr1 is connected to one end of a Schottky diode D1 by way of a low resistance element RL1. A high resistance element RH1 is connected in parallel with the low resistance element RL1 and the Schottky diode D1. Similarly, the base B2 of the second HJBT Tr2 is connected to one end of a Schottky diode D2 through a low resistance element RL2, and a high resistance element RH2 is connected in parallel with the low resistance element RL2 and Schottky diode D2. The other ends of the Schottky diodes D1 and D2 and the high resistance elements RH1 and RH2 are connected to a word line 86 (shown in phantom) formed by the electrode wiring. As shown in Figure 9, the Schottky diode D2 is formed by depositing a Schottky metal 87 (made of Au or Al) on one end portion of an n-GaAs layer 39 extending from the collector region 39C' except the n$^+$-GaAs capping layer 40c'. The low resistance element RL2 is formed by the n-GaAs layer 39' formed between the collector region 39C' and the n-GaAs layer forming the Schottky diode D2. That is, the low resistance element RL2 in the collector region 39C' and the Schottky diode D2 are formed integrally as a unitary structure by the common n-GaAs layer 39'. The high resistance element RH2 is formed integrally with the p$^+$-GaAs layer 36' extending from the external base region 36b'. The Schottky diode D1, the low resistance element RL1 and the high resistance element RH1 connected to the first HJBT Tr1 are the same in arrangement as those of the Schottky diode D2, the low resistance element RL2 and the high resistance element RH2 and therefore need not be described.

If the memory cell is formed in the rule of minimum line/space of 1$\mu$m, the dimensions of one cell become about 11 x 13$\mu$m$^2$. These dimensions are very small, being the same or smaller than that of a composite Si bipolar memory having the same circuit. According to the previously proposed emitter top type HJBT structure, it is generally difficult to form a resistance element by utilising the expitaxial layer. The reason for this is as follows. If the lower n-GaAs layer is employed as the resistance element, the n$^+$-GaAs sub-collector layer is formed therebeneath so that a resistance element of more than several hundreds of ohms needs to be of too large dimensions. Alternatively, if the p$^+$-GaAs layer formed by the ion implantation is employed as the resistance element, the n-GaAs layer is formed therebeneath so that a parasitic capacitance component may exert an adverse influence. The HJBT structure embodying the invention can overcome these difficulties.

According to the above-described embodiments of the invention, since the external capacitance can be made small, the collector capacitance and the emitter capacitance can be reduced. Further, since the external base region is formed to have a high concentration by epitaxial growth, the external base resistance can be reduced and also the base contact dimension can be increased without increasing the capacitance, and the base contact resistance can thus be lowered. Thus, it is possible to obtain a HJBT which can operate satisfactorily at high speed.

Further, according to the above-described embodiments of the invention, since the collector, base and emitter regions are each arranged to face the surface, the trench for attaching the electrode used in the previous proposals becomes unnecessary. Furthermore, the ion implantation technique also becomes unnecessary so that reproducibility of the element can be enhanced. In addition, since the intrinsic base region is formed by the final epitaxial growth operation, the thickness of the base region can be decreased to its limit and the junction can be formed without positional displacement. Thus, this kind of HJBT can be formed as a highly integrated circuit (IC) and fabricated as an integrated circuit with ease.

According to the above-described embodiments of the invention, since the intrinsic base region and the external base region are brought in contact with each other at one edge and, also, the width of the intrinsic base region is made smaller than that of the external base region, the base contact resistance can be decreased even when the device is miniaturised. As a result, the external capacitance at the periphery can be decreased and the collector capacitance and the emitter capacitance can be reduced.

At the same time, the dimension of the external base can be increased without increasing the capacitance and, further, the base contact resistance can be lowered.

In addition, since the barrier layer is interposed between the external base region and the emitter region, which make contact with one another and the compound semiconductor substrate, leakage current between the emitter region and the external base region, through the substrate, can be avoided.

Also, the intrinsic region can be made smaller than the minimum line-width achieved by photolithography and the element can be made smaller.

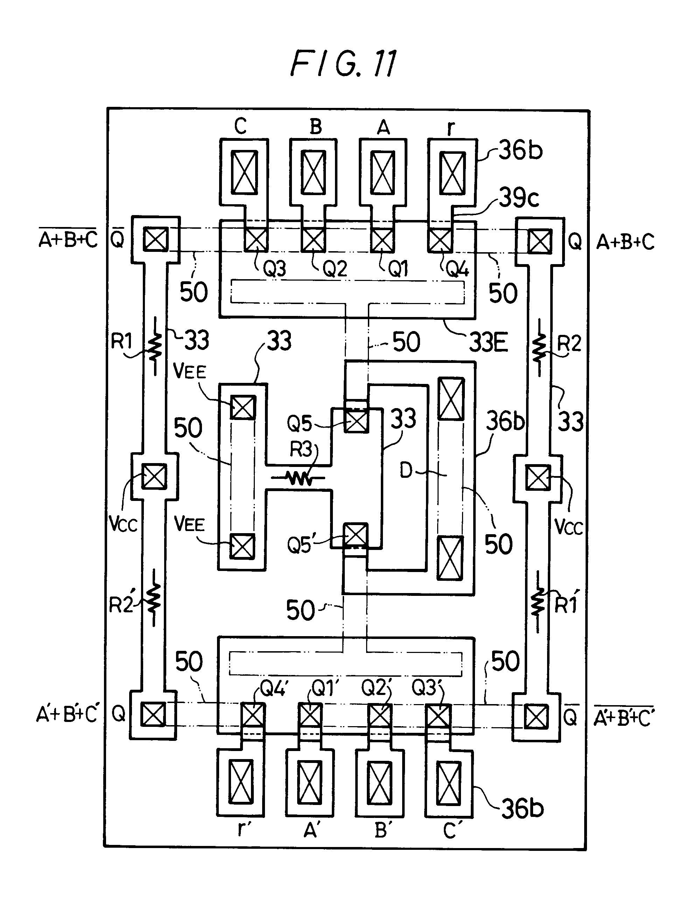

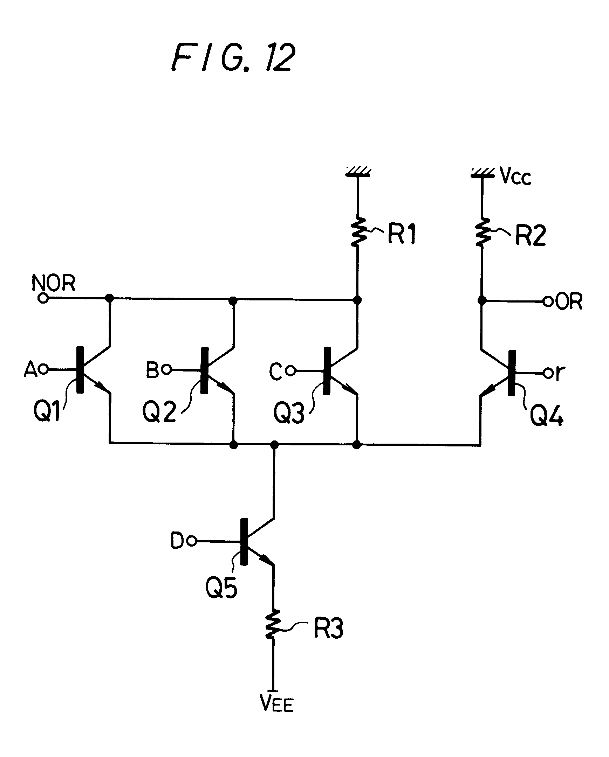

Figure 11 is a plan view of a semiconductor integrated circuit (IC) comprising two gates, each comprising 3-input NOR and OR circuits, which employ collector top type HJBTs 45 as shown in Figures 3A to 3H. Figure 12 shows an equivalent circuit of the upper half portion only of the IC shown in Figure 11. Since the lower half portion thereof is exactly the same as the upper half portion, the parts of the lower half portion corresponding to parts of the upper half portion are designated in Figure 11 by the same references each with a prime superscript and need not be described in detail.

In the IC of Figures 11 and 12, a load resistor R1 commonly connected to the collectors of transistors (HJBTs) Q1, Q2 and Q3, a load resistor R2 connected to the collector of a transistor (HJBT) Q4 and a load resistor R3 connected to the emitter of a transistor (HJBT) Q5 are each formed by the n-AlGaAs layer 33 which forms the emitter region 33E. Also, load resistors R1' and R2' associated with the transistors Q1', Q2', Q3' and Q4' are each formed by the AlGaAs layer 33, in a similar fashion. Metal wiring 50 is indicated in phantom. The respective load resistors R1, R2, R3, R1' and R2' may be formed of the p$^+$-GaAs layer 36 which forms, for example, the external base region 36b.

In the IC of Figure 11, a load resistor or resistors can be realised by the n-AlGaAs layer 33 or by the $p^+$-GaAs layer 36 with ease. Also, as compared with the previously proposed emitter top type HJBT, lead wires are not laid around so that a simplified structure can be achieved. In Figures 11 and 12, references A, A′, B, B′, C, C′, D, r and r′ designate respective inputs while references A + B + C, A′ + B′ + C′, $\overline{A + B + C}$ and $\overline{A′ + B′ + C′}$ designate respective outputs.

Since, in the IC of Figure 11 and 12, a load resistor or resistors is or are formed by the same material layer which forms the emitter region or the base region of the transistor, the IC can be simplified in structure. Therefore, the IC of Figures 11 and 12 is suitable for high speed bipolar circuit apparatus such as CML and the like.

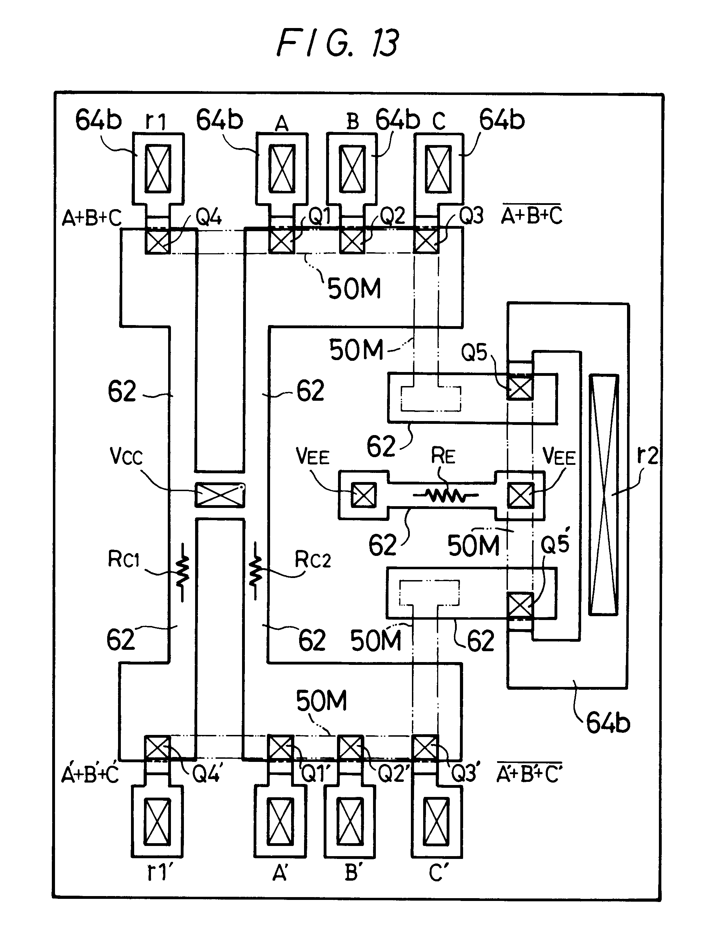

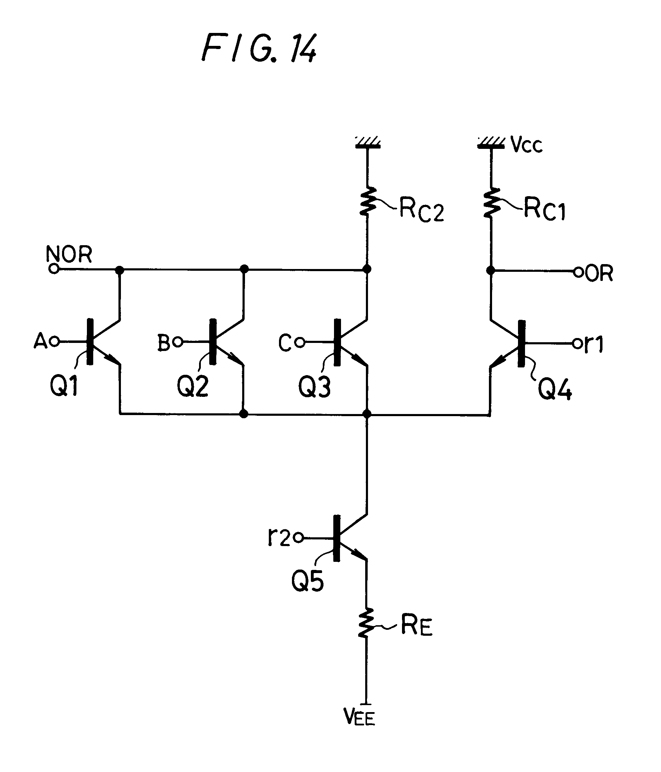

Figure 13 is a plan view of a semiconductor IC comprising two gates, each comprising 3-input NOR and OR circuits, which employ emitter top type HJBTs 72 as shown in Figure 5. Figure 14 shows an equivalent circuit of the upper half portion only of the IC shown in Figure 13. Since the lower half portion thereof is the same as the upper half portion, parts of the lower half portion corresponding to parts of the upper half portion are designated in Figure 13 by like references with prime superscripts.

In the IC of Figures 13 and 14, a load resistor RC2 commonly connected to the collectors of transistors (HJBTs) Q1, Q2 and Q3, a load resistor RC1 connected to the collector of a transistor (HJBT) Q4 and a load resistor RE connected to the emitter of a transistor (HJBT) Q5 are each formed by the n-GaAs layer 62 which forms the collector region 62C. Metal wiring 50 is indicated in phantom. In this case, the respective load resistors RC1, RC2 and RE may be formed by the $p^+$-GaAs layer 64 which forms, for example, the external base region 64b.

In the IC of Figure 13, a load resistor or resistors can be realised by the n-GaAs layer 62 or by the $p^+$-GaAs layer 64 so that the IC can be of simplified structure. In Figure 13, references A, B, C, r2, r1, and r1′ designate respective inputs and references A + B + C, A′ + B′ + C′, $\overline{A + B + C}$ and $\overline{A′ + B′ + C′}$ designate respective outputs.

Since, in the IC of Figures 13 and 14, a load resistor or resistors can be formed of a material layer which is the same as that of the collector region or the base region of the transistor, the IC can be simplified in structure. Therefore, the semiconductor IC of Figures 13 and 14 is particularly suitable for high speed bipolar circuit apparatus such as CML or the like.

**Claims**

1. A collector top type or emitter top type heterojunction bipolar transistor (45;49;72;73) comprising:

an external base region (36b;64b);

an emitter region (33E;66E);

a collector region (39C;62C);

a side surface of the external base region (36b;64b) contacting a side surface of the emitter region (33E;66E) or collector region (39C;62C); and

an intrinsic base region (38B;65B) formed on a region including a boundary between the emitter region (33E;66E) or collector region (39C;62C) and the external base region (36b;64b), the collector region (39C;62C) or emitter region (33E;66E) being formed on the intrinsic base region (38B;65B).

2. A method of manufacturing a collector top type or emitter top type heterojunction bipolar transistor (45;49;72;73), the method comprising:

forming on a substrate (31;61) an emitter region (33E;66E) or collector region (39C;62C), and an external base region (36b; 64b), in such a manner that a side surface of the emitter or collector region contacts a side surface of the external base region; and

sequentially growing an intrinsic base region (38B;65B) and a collector region (39C; 62C) or emitter region (33E;66E) by an epitaxial process on a region including a boundary between the emitter region (33E;66E) or collector region (39C;62C) and the external base region (36b;64b).

3. A semiconductor integrated circuit comprising:
(A) a collector top type heterojunction bipolar transistor (45;49;73) according to claim 1; and
(B) a load resistor made of a material the same as a material layer (33,36) that forms the emitter or base region (33E,36b) of the collector top type heterojunction bipolar transistor.

4. A semiconductor integrated circuit comprising:
(A) an emitter top type heterojunction bipolar transistor (72) according to claim 1; and
(B) a load resistor made of a material the same as that of the collector or base region (62C,64b) of the emitter top type heterojunction bipolar transistor.

**Patentansprüche**

1. Heteroübergang-Bipolartransistor (45, 49, 72, 73) mit Kollektor- oder Emitter-Deckschicht, mit einer äußeren Basiszone (36b, 64b),

mit einer Emitterzone (33E, 66E),

mit einer Kollektorzone (39C, 62C),

mit einer Seitenfläche der äußeren Basiszone (36b, 64b) in Kontakt mit einer Seitenfläche der Emitterzone (33E, 66E) oder Kollektorzone (39C, 62C),

und mit einer auf einem die Grenze zwischen Emitterzone (33E, 66E) oder Kollektorzone (39C, 62C) und äußerer Basiszone (36b, 64b) einschließenden Gebiet ausgebildeten intrinsischen Basiszone (38B, 65B), wobei die Kollektorzone (39C, 62C) oder Emitterzone (33E, 66E) auf der intrinsischen Basiszone (38B, 65B) ausgebildet wird.

2. Verfahren zum Herstellen eines Heteroübergang-Bipolartransistors (45, 49, 72, 73) mit Kollektor- oder Emitter-Deckschicht, mit den folgenden Arbeitsschritten:

Erzeugen einer Emitterzone (33E, 66E) oder Kollektorzone (39C, 62C) sowie einer äußeren Basiszone (36b, 64b) auf einem Substrat (31, 61) dergestalt, daß eine Seitenfläche der Emitter- oder Kollektorzone eine Seitenfläche der äußeren Basiszone kontaktiert;

aufeinanderfolgendes Aufwachsen einer intrinsischen Basiszone (38B, 65B) und einer Kollektorzone (39C, 62C) oder Emitterzone (33E, 66E) mittels Epitaxieverfahren auf einem Gebiet, welches die Grenze zwischen Emitterzone (33E, 66E) oder Kollektorzone (39C, 62C) und äußerer Basiszone (36b, 64b) einschließt.

3. Integrierte Halbleiterschaltung, umfassend

(A) einen Heteroübergang Bipolartransistor mit Kollektor-Deckschicht (45, 49, 73) nach Anspruch 1, und

(B) einen Lastwiderstand aus demselben Material wie die Schicht (33, 36), die die Emitter- oder Basiszone (33E, 36b) des Heteroübergang-Bipolartransistors mit Kollektor Deckschicht ausbildet.

4. Integrierte Halbleiterschaltung umfassend

(A) einen Heteroüberang-Bipolartransistor mit Emitter-Deckschicht (72) nach Anspruch 1, und

(B) einen Lastwiderstand aus demselben Material wie die Kollektor- oder Basiszone (62C, 64b) dei Heteroübergang-Bipolartransistors mit Emitter-Deckschicht.

**Revendications**

1. Transistor bipolaire à hétérojonction du type à collecteur en haut ou du type à émetteur en haut (45 ; 49 ; 72 ; 73) comprenant :

une région de base externe (36b ; 64b) ;

une région d'émetteur (33E ; 66E) ;

une région de collecteur (39C ; 62C) ;

une surface latérale de la région de base externe (36b ; 64b) étant en contact avec une surface latérale de la région d'émetteur (33E ; 66E) ou de la région de collecteur (39C ; 62C) ; et

une région de base intrinsèque (38B ; 65B) formée sur une région incluant une frontière ou limite située entre la région d'émetteur (33E ; 66E) ou la région de collecteur (39C ; 62C) et la région de base externe (36b ; 64b), la région de collecteur (39C ; 62C) ou la région d'émetteur (33E ; 66E) étant formée sur la région de base intrinsèque (38B ; 65B).

2. Procédé de fabrication d'un transistor bipolaire à hétérojonction du type à collecteur en haut ou du type à émetteur en haut (45 ; 49 ; 72 ; 73), le procédé comprenant :

formation sur un substrat (31 ; 61) d'une région d'émetteur (33E ; 66E) ou d'une région de collecteur (39C ; 62C), et d'une région de base externe (36b ; 64b) d'une manière telle qu'une surface latérale de la région d'émetteur ou de collecteur soit en contact avec une surface latérale de la région de base externe ; et

obtention en séquence par croissance d'une région de base intrinsèque (38B ; 65B) et d'une région de collecteur (39C ; 62C) ou d'une région d'émetteur (33E ; 66E) au moyen d'un procédé épitaxial sur une région incluant une limite ou frontière située entre la région d'émetteur (33E ; 66E) ou la région de collecteur (39C ; 62C) et la région de base externe (36b ; 64b).

3. Circuit intégré à semiconducteur comprenant :

(A) un transistor bipolaire à hétérojonction du type à collecteur en haut (45 ; 49 ; 73) selon la revendication 1 ; et

(B) une résistance de charge réalisée à partir du même matériau que celui d'une couche de matériau (33, 36) qui forme la région d'émetteur ou de base (33E, 36b) du transistor bipolaire à hétérojonction du type à collecteuren haut.

4. Circuit intégré à semiconducteur comprenant :

(A) un transistor bipolaire à hétérojonction du type à émetteur en haut (72) selon la revendication 1 ; et

(B) une résistance de charge réalisée à partir du même matériau que celui de la région de collecteur ou de base (62C, 64b) du transistor bipolaire à hétérojonction du type à émetteur en haut.

FIG. 1

13

p-GaAs

p-AlGaAs

p-GaAs

n+-GaAs

n-GaAs

n-AlGaAs

p-GaAs

n-GaAs

n+-GaAs

GaAs

# FIG. 2

17

10      7    14       19   16    3      14         9      15    12    11

$n^+$-GaAs

n-GaAs        P-GaAs

p-GaAs

p-AlGaAs

n-AlGaAs

5      $n^+$-GaAs       4

GaAs

8        18                       1      8

EP 0 289 343 B1

FIG. 3A

35     34     n–$Al_X Ga_{1-X}As$     33     32

n–$Al_{0.3} Ga_{0.7}As$

i–$Al_{0.5} Ga_{0.5}As$

GaAs

31

FIG. 3B

34     35

33E     32

n–$Al_{0.3} Ga_{0.7}As$

i–$Al_{0.5} Ga_{0.5}As$

GaAs

31

FIG. 3C

36     33E     34     35     32

$p^+$–GaAs     n–$Al_{0.3} Ga_{0.7}As$     $p^+$–GaAs

i–$Al_{0.5} Ga_{0.5}As$

GaAs

31

14

## FIG. 3D

40    39    34    $n^+$-GaAs    38    33E    36

n-GaAs

$p^+$-GaAs    n-$Al_{0.3}Ga_{0.7}As$

i-$Al_{0.5}Ga_{0.5}As$

GaAs

32    31

## FIG. 3E

40    39

n-GaAs    34

$p^+$-GaAs    32

n-$Al_{0.3}Ga_{0.7}As$

i-$Al_{0.5}Ga_{0.5}As$

GaAs

36b    31

## FIG. 3F

45

44   39C   40c   43   38B   42   34   41

$SiO_2$    n    $SiO_2$

$p^+$-GaAs    n-$Al_{0.3}Ga_{0.7}As$

i-$Al_{0.5}Ga_{0.5}As$

GaAs

32    36b    33E    31

# F I G. 3G

W3

W2

W1

52

51

33E

# F I G. 3H

44

43

42

W3

W2

W1

36b

39C(38B)

33E

## FIG. 4A

SiN    AlGaAs    35    47    $n-Al_x Ga_{1-x} As$

$n^+-GaAs$

$n-Al Ga As$

$i-Al_{0.5} Ga_{0.5} As$

GaAs

46    34    31    32    33

## FIG. 4B

35

34    47

33E    46

32

$n^+-GaAs$

$n-AlGaAs$

$i-Al_{0.5} Ga_{0.5} As$

GaAs

31

## FIG. 4C

36    35    33E    46    47    34    32

$p^+-GaAs$    $n^+-GaAs$

$n-Al GaAs$

$i-Al_{0.5} Ga_{0.5} As$

GaAs

31

FIG. 4D

36    33E    34    46    47    32

p⁺-GaAs

n-AlGaAs

i-Al$_{0.5}$Ga$_{0.5}$As

n⁺-GaAs

GaAs

31

FIG. 4E

48    47    39    40

38    46    34

n⁺-GaAs

n-GaAs

p⁺-GaAs

n⁺-GaAs

n-AlGaAs

i-Al$_{0.5}$Ga$_{0.5}$As

S.I.GaAs

32

31

33E

FIG. 4F

39    40    36b    38B    46e    47

n-GaAs    n⁺-GaAs    n⁺-GaAs    34    33E

p⁺-GaAs

n-AlGaAs

32

i-Al$_{0.5}$Ga$_{0.5}$As

GaAs

31

EP 0 289 343 B1

FIG. 4G

FIG. 4H

FIG. 4I

19

FIG. 5A

FIG. 5B

FIG. 5C

## FIG. 5D

66  64  67  65  n⁺-GaAs / n-AlGaAs / p⁺-GaAs  62C

p⁺-GaAs  n-GaAs

GaAs

61

## FIG. 5E

54  67e  66E  65B  62C

n⁺-GaAs / n-AlGaAs

64  p⁺-GaAs  n-GaAs

GaAs

61

## FIG. 5F

n⁺-GaAs  n-AlGaAs

53  62C

64b  p⁺-GaAs  n-GaAs  61

GaAs

## F I G. 5G

72    69    66E    65B

71    n⁺-GaAs    67e    70    68

n-AlGaAs

SiO₂    SiO₂

p⁺-GaAs    n-GaAs

GaAs

64b    62C    61

## F I G. 5H

71    64b    69    62C    70

72

EP 0 289 343 B1

FIG. 6A

FIG. 6B

FIG. 6C

FIG. 6D

23

# F I G. 6E

# F I G. 6F

FIG.7

FIG.9

## FIG. 8

## FIG. 10

FIG. 11

FIG. 12

# F I G. 13

## *FIG. 14*